# EUROPEAN PATENT APPLICATION

(11) **EP 4 199 050 A1**
(43) Date of publication of application: **21.06.2023**
(21) Application number: 21214813.4
(22) Date of filing: 15.12.2021
(51) Int. Cl.: H01L 21/683, H01L 25/00, H01L 23/00, H01L 23/544

(54) **A METHOD FOR BONDING DIES TO A CARRIER SUBSTRATE**

(71) Applicant: IMEC VZW, 3001 Leuven (BE)
(72) Inventor: Bex, Pieter, 3583 Paal (BE); Phommahaxay, Alain, 1490 Court Saint Etienne (BE)
(74) Representative: Patent Department IMEC

(57) **Abstract**

According to the invention, a plurality of dies (4) are temporarily attached to a rigid transfer substrate (1) through a light-releasable temporary bonding layer (2). The transfer substrate (1) is a rigid substrate that is transparent for the type of light that is capable of releasing the dies (4), i.e. the type of light that is capable of removing or releasing the light-releasable layer (2). This may be laser light or other visible or invisible light such as UV, IR or LED light. The assembly comprising the transfer substrate (1) and the dies (4) is positioned relative to a carrier substrate (15) with the dies (4) facing respective interface areas (16) on a surface of the carrier substrate (15). By illuminating a die (4) through the back side of the transfer substrate (1), the die is released and transferred to the carrier substrate (15). The method is suitable for bonding dies to a carrier without any mechanical handling of individual dies.

## Description

### Field of the Invention

The present invention is related to techniques applicable in semiconductor processing for the bonding of components, in particular to the bonding of individual dies to a carrier substrate such as a semiconductor wafer or an interposer chip. The term 'die' is used in the present description for indicating a component of limited dimensions having a given functionality when mounted on a receiving surface of the carrier substrate.

### State of the art.

Accurate die placement and bonding processes play an important role in the production of heterogeneous and 3D integrated devices, and advanced packaging in general. Solder micro-bump-based die stacking is the process of choice for the assembly of products like High Bandwidth Memory (HBM), and other 3D and 2.5D (interposer) integrated devices. The interconnect pitch of these devices is typically in the range of 50 µm to 40 µm. Thermal Compression Bonding (TCB) is the preferred bonding process for such small pitch interconnects. These conventional solder-based micro-bump interconnects in combination with a TCB process can be further scaled down to around 20µm pitch. New solutions like the embedded bump concept, can allow a further scaling down to 7 µm or even 5 µm interconnect pitch, while still using a TCB process.

When moving to pitches below 5 µm, a further increase of placement accuracy below 1 µm is required. These placement accuracy requirements are however not compatible with a heated TCB process. Moreover, further scaling of solder-based bumps is not feasible, since the aspect ratio becomes too large, and therefore the bumps become too fragile.

One known solution to overcome the heated process and solder bump scaling issues, is a transition to hybrid metal/dielectric, for example copper/dielectric bonding. Copper pads are embedded in a dielectric and planarized to achieve very smooth and flat surfaces. After cleaning and activation of both bonding surfaces, a room temperature bonding step is performed, typically followed by an anneal step to increase the bonding strength. This dielectric/copper hybrid bonding approach is already being used in volume production in a wafer-to-wafer (W2W) mode. The best-known example is the production of backside illuminated CMOS image sensors. Next to hybrid bonding, also pure dielectric bonding can be used for layer transfer activities.

However, a direct transfer of the existing W2W dielectric and hybrid bonding techniques to a die-to-wafer (D2W) process is not straightforward. Since no solder or additional polymer layer in between the 2 surfaces is present anymore, any particle or foreign material will hinder good bonding. The conventional die-to-wafer process flow applied for solder-based bonding of individual dies involves mechanical handling of individual dies to remove them from a dicing tape and transfer them to a bondhead, which is then aligned to the bonding position on the wafer.

However, the direct dielectric and hybrid bonding process requires a surface cleaning and activation process directly before the bonding step. Applying the conventional process flow would mean that both the cleaning and activation of the dies need to be performed on a single die level which would represent a time-consuming step making it impossible to achieve a high throughput. Also, control of the deformation of the thin dies is critical to eliminate any air entrapment/voiding in the bond interface. Such control is difficult to realize in the conventional process flow because of the mechanical handling of the individual dies.

### Summary of the invention

The invention aims to provide a method for bonding a die to a carrier substrate that does not suffer from the above-described problems. This aim is achieved by the methods disclosed in the appended claims.

According to the invention, a plurality of dies, preferably semiconductor dies such as integrated circuit chips, are temporarily attached to a rigid transfer substrate through a light-releasable temporary bonding layer. The dies may be attached directly to said light-releasable layer or through an additional temporary bonding layer. The light-releasable layer itself may be attached directly to the transfer substrate or via an additional temporary bonding layer. The transfer substrate is a rigid substrate that is transparent for the type of light that is capable of releasing the dies, i.e. the type of light that is capable of removing or releasing the light-releasable layer. This may be laser light or other visible or invisible light such as UV, IR or LED light. The assembly comprising the transfer substrate and the dies is positioned relative to a carrier substrate with the dies facing respective interface areas on a surface of the carrier substrate. By illuminating a die through the back side of the transfer substrate, the die is released and transferred to the carrier substrate. The method is suitable for bonding dies to a carrier without any mechanical handling of individual dies.

The invention is in particular related to a method for bonding a die to a carrier substrate comprising the steps of :
- providing the carrier substrate, said carrier substrate having at least one interface area on a surface of the substrate, said interface area being configured to receive one die,
- providing an assembly comprising a rigid transparent transfer substrate, a light-releasable bonding layer on a front surface of the transfer substrate and a plurality of dies attached at one side of the dies to the light-releasable bonding layer, the dies having a bonding surface on their opposite side, the dies being physically separated from each other,
- aligning the assembly to the carrier substrate with the dies facing the carrier substrate, so that the bonding surface of one or more dies is aligned to respective one or more interface areas of the carrier substrate,
- illuminating one of said one or more dies through the back surface of the transparent transfer substrate, to thereby release the die and transfer the die to an interface area of the carrier substrate. The transfer is done while essentially maintaining the alignment, so that the bonding surface of the die is in physical contact with the interface area, i.e. specific areas of the respective surfaces are in mutual contact such as dielectric bonding layers and/or metal contact structures. Additional steps may be required for forming a permanent bond, such as a bonding anneal step, for example for realizing a chemical bond between dielectric bonding surfaces or for melting a number of solder bumps.
In the above method, the transfer substrate is transparent in the sense that is it transparent to the type of light applicable for releasing the light-releasable bonding layer. Said assembly is not limited to embodiments wherein the light-releasable bonding layer is in direct contact with the transfer substrate, nor to embodiments wherein the dies are in direct contact with the light-releasable layer. In both cases, one or more intermediate layers could be present.

According to an embodiment, the method further comprises producing said assembly by the steps of :
- providing the transfer substrate,
- producing the light-releasable layer on the front surface of the transfer substrate,
- producing a layer comprising said plurality of dies on the light-releasable layer,
- performing a dicing step to physically separate the dies from each other by a plurality of dicing lanes.
According to an embodiment, the illumination step is performed by illuminating the totality of the surface of the die through the back side of the transfer substrate.

According to an embodiment, the illumination step is performed by a first illumination of a location at the center of the die, to thereby release the die at said central location and obtain a physical contact between the die and the carrier substrate at said central location, followed by a second illumination of the totality of the die. According to an embodiment, said first and second illumination are each performed by applying one pulse of a pulsed laser.

According to an embodiment, the illumination step is performed by directing laser light at the die.

According to an embodiment, said illumination step is performed by applying one pulse of a pulsed laser.

According to an embodiment, the illumination step is performed by one of the following : a UV light source, an IR light source, a LED light source.

The method may further comprise additional steps after transferring one or more dies to respective interface areas of the carrier substrate, for forming a permanent bond between the one or more dies and the respective interface areas. Said additional steps may comprise a bonding anneal step.

The method may further comprise one or more surface preparation steps performed on the bonding surfaces of the plurality of dies while said dies are attached to the transfer substrate.

According to an embodiment, the bonding surface of the die comprises first contact pads embedded in a first dielectric layer that is coplanar with the first contact pads, wherein the interface area of the carrier substrate comprises second contact pads embedded in a second dielectric layer that is coplanar with the second contact pads, and wherein bonding the die to the interface area comprises bringing the first and second contact pads together and bringing the first and second dielectric layers together.

According to an embodiment, an additional temporary bonding layer is present between the transfer substrate and the light-releasable layer and/or between the light-releasable layer and the plurality of dies.

### Brief description of the figures

Figure 1a illustrates a transfer wafer comprising a laser-releasable layer and a number of dies, before the performance of a dicing step. Figure 1b shows a detail of one of the dies.
Figure 2 shows the result of the dicing step on the wafer of Figure 1.
Figure 3a illustrates how the assembly shown in Figure 2a is flipped 180° and aligned to a carrier substrate. Figure 3b shows a detail of one of the dies when it is aligned to an interface area on the carrier substrate.
Figure 4 illustrates the illumination of one of the dies through the back side of the transfer wafer, by a laser beam.
Figure 5a illustrates the release and bonding of the illuminated die. Figure 5b shows a detail of the bonded die.
Figures 6a to 6b illustrate an embodiment wherein the illumination step takes place in two consecutive stages.

### Detailed description of the invention

According to the invention, an assembly is provided comprising a transfer substrate carrying on its front surface a light-releasable bonding layer and a plurality of separate dies releasably attached to the bonding layer. The term 'light-releasable layer' is defined within the present context as a layer of which the bonding effect can be removed by the impact of light of a given type, including light in the visible range as well as in the invisible range to thereby release the dies from the transfer substrate. Suitable light types include laser light, UV (ultraviolet) light, IR (infra-red) light or LED (light emitting diode) light. The transfer substrate is a rigid substrate that is transparent for the type of light applicable for releasing the light-releasable bonding layer. A preferred embodiment involves the use of laser light impacting a laser-releasable bonding layer through the back surface of the transfer substrate, to thereby release the dies.

A method for producing the above-described assembly is described hereafter, for the case of a laser-releasable layer. The materials and dimensions described hereafter are mentioned by way of example and are not limiting the scope of the present invention.

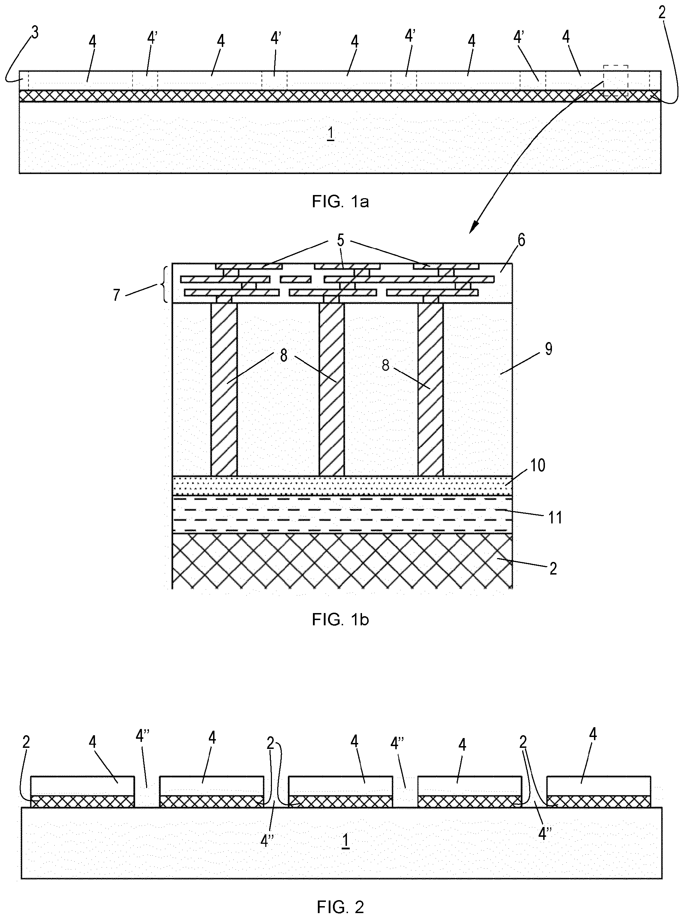

Figure 1a illustrates a small portion of the transfer substrate 1. In this particular embodiment, the transfer substrate is a glass wafer 1 comprising on its front surface a laser-releasable bonding layer 2, and attached to said bonding layer 2, a layer 3 of semiconductor dies 4 that have not been separated from each other. The outer limits of the individual dies 4 are visualized in Figure 1a by thin lines. The spacings 4' between these lines are to be removed by a dicing process, in order to separate the dies 4 from each other.

The die layer 3 may have the same transverse dimensions as the glass wafer 1. The glass wafer 1 could for example be a round wafer having the dimensions of a standard silicon process wafer, for example having a diameter of 200mm or 300mm. Layer 3 may be produced by semiconductor processing techniques, which are well known and which do not form the focus of the present invention. These techniques may involve front end of line (FEOL) and back end of line (BEOL) processing on the front surface of a silicon process wafer, flipping the silicon wafer and attaching it front face down to the glass wafer 1 provided with the laser-releasable bonding layer 2, and thinning the silicon wafer from the back side, followed by additional processing on the thinned back-side surface of the silicon wafer for producing back side contacts of the semiconductor dies. Said back side contacts may be connected to a redistribution layer at the back of the dies, that is in turn connected to the front of the dies by through-silicon-via connections. According to a preferred embodiment illustrated in the detail in Figure 1b, the back side contacts are metal contact pads 5 embedded in a dielectric material 6 and suitable for hybrid bonding, wherein the dielectric material 6 is bonded to a dielectric material of a receiving surface by direct dielectric-to-dielectric bonding and the contact pads 5 are bonded to receiving metal contact pads by direct metal-to-metal bonding. In order to obtain the hybrid bond, the bonding surface of the dielectric layer 6 is coplanar with the bonding surface of the contact pads 5, which may be realized by planarization techniques known as such in the art.

Figure 1b also shows the redistribution layer 7, TSV connections 8 through the thinned silicon wafer 9 and the FEOL and BEOL portions 10 and 11 of one of the dies. The detail image in Figure 1b is not drawn to scale and serves only to visualize the above-described features. For example, the number of back side contacts 5 of one die may be much higher in a real semiconductor die.

The thickness of layer 3 may be in the order of 500nm to several micrometres. The laser-releasable layer 2 may be a layer of material known in the art, such as for example the Brewerbond^{®}701 material, applied in a thickness between about 100 nm and 200nm. In any embodiment of the invention, an additional temporary bonding layer could be present between the transfer substrate 1 and the die layer 3 or between the light-releasable layer 2 and the die layer 3. In the embodiment shown for example, a layer of Brewerbond^{®} C1301 may be applied directly on the glass wafer 1 with the laser-releasable Brewerbond^{®}701 layer 2 directly on the C1301 layer, and the die layer 3 attached to the laser-releasable layer 2.

The result of a dicing process applied to the die layer 3 is illustrated in Figure 2, wherein the dies 4 are now separated by dicing lanes 4". Known dicing techniques are applicable such as plasma dicing or dicing before grinding (DBG).

In the embodiment shown, the laser releasable layer 2 is removed also in the dicing lanes 4". Depending on the type of laser release material used and the dicing method used, this layer 2 could however be maintained in the dicing lanes.

Preferably, the dicing step is followed by one or more surface treatment steps which may include a cleaning step for removing any contaminants and residue material from the dicing step, and a pre-bonding surface treatment such as a plasma-induced surface activation. These preparatory steps are known as such and may be implemented according to known methods.

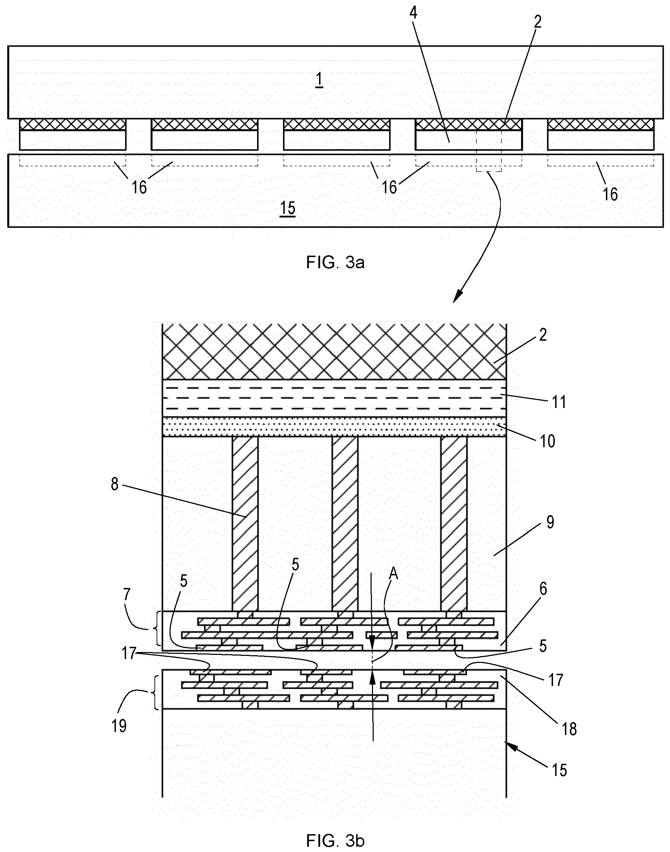

In accordance with the illustrated embodiment of the method of the invention, and with reference to Figure 3a, the thus obtained assembly is then flipped and positioned above a carrier substrate 15. The carrier substrate may for example be an interposer substrate that has a number of dedicated interface areas 16 configured to receive a respective number of the dies 4 bonded to said interface areas 16. As illustrated in the detail in Figure 3b, the interface areas 16 comprise contact pads 17 embedded in a layer 18 of dielectric material that is coplanar with the contact pads 17 and connected to a redistribution layer 19. The contact pads 17 on the carrier substrate 1 are similar in size to the contact pads 5 of the die 4 that is to be bonded to the carrier substrate 15.

The assembly comprising the transfer wafer 1 and the dies 4 is positioned with the dies 4 facing the interface areas 16 and with both bonding surfaces essentially parallel to each other and as close as possible from each other without making physical contact. The achievable distance A (see Figure 3b) between the dies 4 and the interface areas 16 depends on the accuracy of the positioning tools applied in the method. The distance A may for example be between 1 µm and 10 µm.

The assembly and the carrier substrate 15 are aligned to each other so as to align the contact pads 5 of at least one of the dies 4 to the contact pads 17 of one of the interface areas 16. This may be done by any alignment technique known in the art of wafer-to-wafer bonding, for example involving the inclusion of alignment markers on the carrier substrate 15 and/or on the glass transfer wafer 1. When visible light is used for the alignment, the alignment takes place before bringing the assembly and the carrier substrate 15 close together. When infra-red light is used, the alignment can be done after bringing the assembly and the carrier substrate close together.

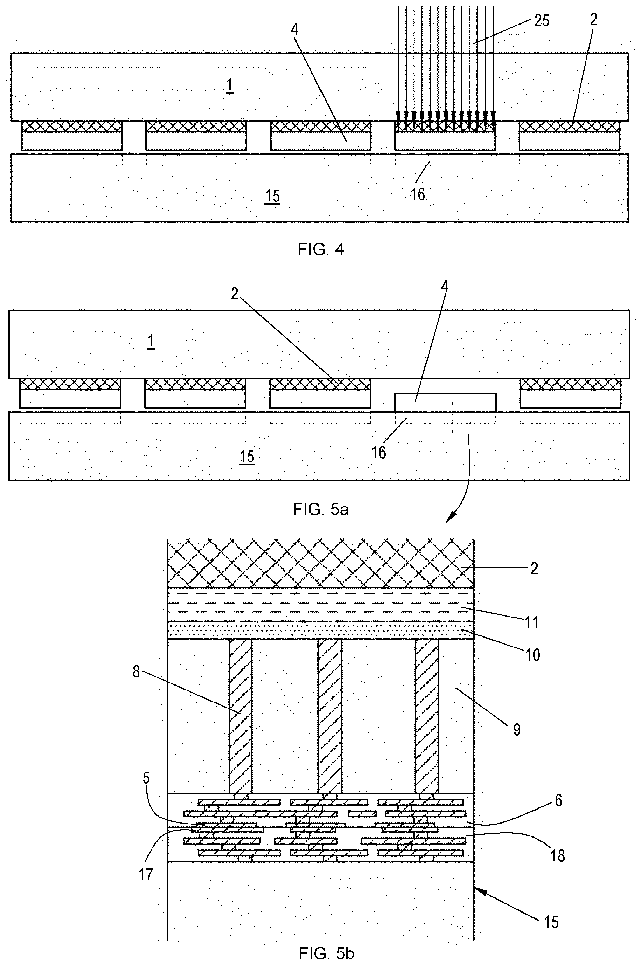

With reference to Figure 4, a laser beam 25 then illuminates one of the dies 4 through the back surface of the glass transfer wafer 1 and through the glass wafer as such. The laser light impacts the laser-releasable layer 2, which is essentially removed by the interaction with the laser light, thereby releasing the die 4 from the transfer wafer 1 and transferring the die 4 to the carrier substrate, without any essential loss of alignment. This is illustrated in Figure 5a. A detail of the transferred die is shown in Figure 5b, illustrating that the contact pads 5 of the die are in physical contact with the contact pads 17 of the carrier substrate 15.

This step is then preferably followed by a bond anneal as known as such in the art, for realising a permanent hybrid bond, i.e. a direct dielectric-to-dielectric bond between the dielectric bonding layers 6 and 18 of the die 4 and the carrier 15 and a direct metal-to-metal bond between the contact pads 5 of the die 4 and the contact pads 17 of the carrier substrate 15. If an additional temporary bonding layer is present between the dies 4 and the laser-releasable layer 2, this temporary bonding layer is transferred together with the die 4, and must therefore be removed by a cleaning step after the permanent bond has been realised.

The illumination with the laser beam 25 takes place during an illumination time of less than 1 s, preferably considerably less than 1 s. It may be sufficient to apply one pulse of a pulsed laser beam for releasing one die 4. The illumination time may however vary within a broad range, depending on the dimensions of the dies 4, the thickness of the laser-releasable layer 2 and other parameters.

According to an embodiment, the diameter of the laser beam 25 is such that the totality of the die surface is illuminated by the full beam.

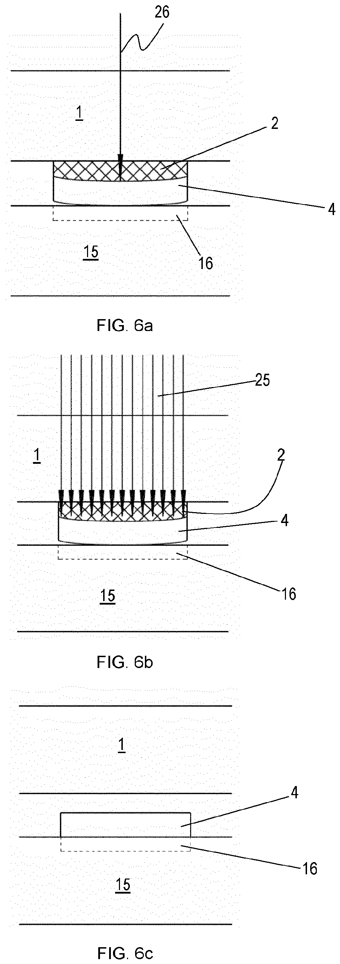

According to a specific embodiment, the laser release process takes place in two consecutive stages, illustrated in Figures 6a and 6b. With reference to Figure 6a, a first laser illumination 26, for example one laser pulse of a pulsed laser, is focused on a localised illumination area in the centre of the die 4. This may be done by applying a diaphragm between the laser source and the die 4. The localised laser interaction removes or releases the material of the laser-releasable layer 2 at the central location only, causing the die 4 to slightly bend downward centrally, and enter into contact with the carrier substrate 15. This is followed by an illumination by the full laser beam width 25 as illustrated in Figure 6b, for example again during one pulse. The second illumination removes the remaining laser-releasable material of layer 2, but because there is already a central contact area with the carrier substrate 15, the contact between the die 4 and the carrier substrate 15 propagates from this central area until the die 4 is in contact with to the carrier substrate 15 across the totality of one of its dedicated interface areas 16, as illustrated in Figure 6c. This sequence reduces the risk of misalignment occurring during the transfer of the die 4 from the transfer wafer 1 to the carrier substrate 15. Also, due to the progressive propagation of the contact, the risk of air becoming trapped between the die 4 and the interface area 16 is reduced.

The method of the invention enables a higher throughput compared to an approach wherein dies are picked up and bonded separately, as the bonding preparation steps can be performed simultaneously on a plurality of dies attached to the transfer substrate 1. Mechanical handling of individual dies is avoided, thereby reducing the risk of deformation of the dies. After all the dies 4 have been released from the transfer substrate 1, this transfer substrate 1 can be re-used for subsequent die-to-wafer bonding operations.

A number of variations are possible within the scope of the invention as defined by the independent claims. Alignment may be performed for one or more dies 4 simultaneously, followed by the release of said one or more dies by subsequent illuminations of said one or more dies, and without re-alignment between the illuminations. Alternatively, a separate alignment step could be performed for each die 4, each time followed by illumination and release of the aligned die 4.

The invention is not limited to the use of laser light for releasing the dies 4. Other light sources that can be used in the method of the invention include UV (Ultraviolet) light sources or LED (Light Emitting Diode) light sources, provided that the light-releasable layer 2 is formed of a material that is releasable by a light beam produced by these sources. Some of these light sources may require a diaphragm for producing a beam that covers the full area of a die 2, and if the embodiment of Figures 6a and 6b is applied, for further focusing the beam at a central location of the die 4.

The method is not only applicable to dies 4 comprising electrical contacts on their bonding surface, but can also be applied for bonding dies that are not to be electrically connected to the carrier substrate, but merely bonded thereto by a direct dielectric-to-dielectric bond. The method may be the same as described above except that the contact pads 5 and 17 are absent and blanket dielectric bonding layers are covering both bonding surfaces.

The method of the invention finds its primary use for realising hybrid bonds as described above between the dies 4 and the carrier substrate 15, for which the absence of individual die handling is particularly advantageous in terms of avoiding die deformation and contamination of the bonding surfaces. The method is however applicable also to other bonding techniques such as solder bonding.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

Unless specifically specified, the description of a layer or a component being present, deposited or produced 'on' another layer or substrate or 'attached to' another layer or substrate, includes the options of
- said layer or component being present, produced or deposited directly on, i.e. in physical contact with, said other layer or substrate, and
- said layer or component being present, produced or deposited on one or a stack of intermediate layers between said layer and said other layer or substrate.

## Claims

1. A method for bonding a die (4) to a carrier substrate (15) comprising the steps of :
- providing the carrier substrate (15), said carrier substrate having at least one interface area (16) on a surface of the substrate, said interface area (16) being configured to receive one die (4),
- providing an assembly comprising a rigid transparent transfer substrate (1), a light-releasable bonding layer (2) on a front surface of the transfer substrate and a plurality of dies (4) attached at one side of the dies to the light-releasable bonding layer (2), the dies having a bonding surface on their opposite side, the dies being physically separated from each other,
- aligning the assembly to the carrier substrate (15) with the dies facing the carrier substrate, so that the bonding surface of one or more dies (4) is aligned to respective one or more interface areas (16) of the carrier substrate (15),
- illuminating one of said one or more dies (4) through the back surface of the transparent transfer substrate (1), to thereby release the die (4) and transfer the die to an interface area (16) of the carrier substrate (15).

2. The method according to claim 1, further comprising producing said assembly by the steps of:
- providing the transfer substrate (1),
- producing the light-releasable layer (2) on the front surface of the transfer substrate (1),
- producing a layer (3) comprising said plurality of dies (4) on the light-releasable layer (2),
- performing a dicing step to physically separate the dies (4) from each other by a plurality of dicing lanes (4").

3. The method according to claim 1 or 2, wherein the illumination step is performed by illuminating the totality of the surface of the die (4) through the back side of the transfer substrate (1).

4. The method according to any one of claims 1 to 3, wherein the illumination step is performed by a first illumination of a location at the center of the die (4), to thereby release the die at said central location and obtain a physical contact between the die and the carrier substrate (15) at said central location, followed by a second illumination of the totality of the die (4).

5. The method according any one of the preceding claims, wherein the illumination step is performed by directing laser light (25,26) at the die (4).

6. The method according to any one of claims 1 to 3, wherein said illumination step is performed by applying one pulse of a pulsed laser.

7. The method according to claim 4, wherein said first and second illumination are each performed by applying one pulse of a pulsed laser.

8. The method according to any one of claims 1 to 4, wherein the illumination step is performed by one of the following : a UV light source, an IR light source, a LED light source.

9. The method according to any one of the preceding claims, further comprising additional steps after transferring one or more dies (4) to respective interface areas (16) of the carrier substrate (15), for forming a permanent bond between the one or more dies (4) and the respective interface areas (16).

10. The method according to claim 9, wherein said additional steps comprise a bonding anneal step.

11. The method according to any one of the preceding claims, further comprising one or more surface preparation steps performed on the bonding surfaces of the plurality of dies (4) while said dies (4) are attached to the transfer substrate (1).

12. The method according to any one of the preceding claims, wherein the bonding surface of the die (4) comprises first contact pads (5) embedded in a first dielectric layer (6) that is coplanar with the first contact pads (5), and wherein the interface area (16) of the carrier substrate (15) comprises second contact pads (17) embedded in a second dielectric layer (18) that is coplanar with the second contact pads (17), and wherein bonding the die (4) to the interface area (16) comprises bringing the first and second contact pads (5,17) together and bringing the first and second dielectric layers (6,18) together.

13. The method according to any one of the preceding claims, wherein an additional temporary bonding layer is present between the transfer substrate (1) and the light-releasable layer (2) and/or between the light-releasable layer (2) and the plurality of dies (4).
